# EUROPEAN PATENT APPLICATION

(11) **EP 1 967 808 A1**
(43) Date of publication of application: **10.09.2008**
(21) Application number: 07250929.2
(22) Date of filing: 06.03.2007
(51) Int. Cl.: F28D 15/02

(54) **Cooling device for electronic components**

(71) Applicant: Coolit Systems Inc., Calgary, Alberta T2A 7V8 (CA)
(72) Inventor: Scott, Alexander Robin Walter, Okotoks, Alberta, T1S 1C5 (CA)
(74) Representative: Chapman, Paul Nicholas

(57) **Abstract**

A fluid heat exchanger includes: a base (12), a heat pipe (16) including an evaporator portion (18) thermally coupled to the base and a condenser portion (20); a coolant block portion (14) thermally coupled to the condenser portion of the heat pipe, the coolant block portion including a liquid tight passage extending from a passage inlet (24) to a passage outlet (24).

## Description

### Field

The present invention relates to a cooling device for electrical and electronic components and, in particular, a liquid heat exchanger.

### Background

Heat generating electrical or electrical components include for example memory chips, CPUs, voltage regulators, drivers, etc. and generate heat that is deleterious to their operation and the operation of other system components.

Fluid heat exchangers are used to conduct heat away from heat generating electrical or electrical components and into a passing fluid such as air. A fluid heat exchanger generally may include a thermal plate and a heat-dissipating portion. The thermal plate is installed in thermal communication with a heat source such as directly or indirectly on a heat generating electrical or electronic component. The heat-dissipating portion is thermally coupled to the thermal plate to conduct heat energy therefrom. Coolant fluid passes through the heat-dissipating portion to accept heat energy therefrom. Where liquid coolant fluid is used, for example, the liquid is pumped through a block, sometimes called a "water block", forming at least part of the heat dissipating portion where the liquid accepts the heat.energy and then the heated liquid is pumped to a heat sink located at some distance from the block. It will be appreciated that various liquid coolants are known such as freon, water, alcohols, glycols, etc.

General information concerning fluid heat exchangers, is contained in applicant's corresponding published application WO 03/007372, dated January 23,2003 and is incorporated herein by reference.

### Summary

In accordance with another broad aspect of the present invention, there is provided a fluid hear exchanger comprising: a base, a heat pipe including an evaporator portion thermally coupled to the base and a condenser portion; a coolant block portion thermally coupled to the condenser portion of the heat pipe, the coolant block portion including a liquid tight passage extending from a passage inlet to a passage outlet.

In accordance with another broad aspect of the present invention, there is provided a cooling system for a heat-generating component, the cooling system comprising; a fluid heat exchanger including a base, a heat pipe including an evaporator portion thermally coupled to the base and a condenser portion; a coolant block portion thermally coupled to the condenser portion of the heat pipe, the coolant block portion including a liquid tight passage extending from a passage inlet to a passage outlet.

It is to be understood that other aspects of the present invention will become readily apparent to those skilled in the art from the following detailed description, wherein various embodiments of the invention are shown and described by way of illustration. As will be realized, the invention is capable for other and different embodiments and its several details are capable of modification in various other respects, all without departing from the spirit and scope of the present invention. Accordingly the drawings and detailed description are to be regarded as illustrative in nature and not as restrictive.

### Description of the Drawings

Referring to the drawings wherein like reference numerals indicate similar parts throughout the several views, several aspects of the present invention are illustrated by way of example, and not by way of limitation, in detail in the figures, wherein:
Figure 1 is a side elevation of an assembled fluid heat exchanger.
Figure 2 is an end elevation of the fluid heat exchanger of Figure 1.
Figure 3 is a bottom plan view of the fluid heat exchanger of Figure 1.
Figure 4 is a top plan view of a fluid heat exchanger base and heat pipes with the coolant block portion removed.
Figure 5 is a side elevation of the assembly of Figure 4.
Figure 6 is a schematic view of a cooling system for a heat-generating component.

### Description of the Various Embodiments

The detailed description set forth below in connection with the appended drawings is intended as a description of various embodiments of the present invention and is not intended to represent the only embodiments contemplated by the inventor. The detailed description includes specific details for the purpose of providing a comprehensive understanding of the present invention. However, it will be apparent to those skilled in the art that the present invention may be practiced without these specific details.

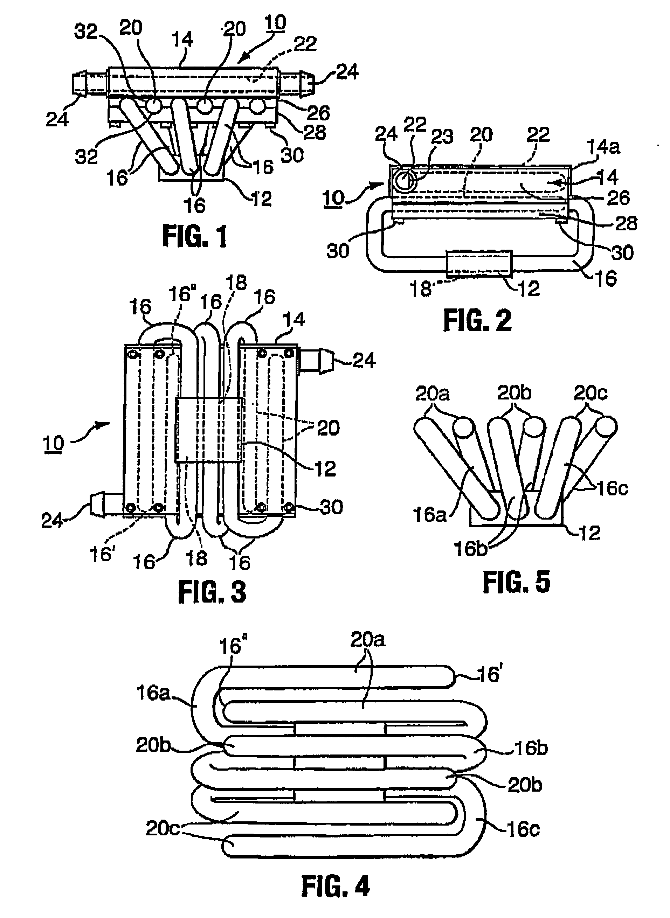

Referring to Figures 1 to 5, a fluid heat exchanger 10 is shown that includes a base 12, a coolant block portion 14 and one or more heat pipes 16, each heat pipe including an evaporator portion 18 and a condenser portion 20. The evaporator portion of each heat pipe is attached and thermally coupled to the base and the condenser portion of each heat pipe is attached and thermally coupled to coolant block portion 14.

It is to be understood that fluid heat exchanger 10 may be used to conduct heat away from a heat-generating component such as, for example, a component of a computer or other electric or electronic device. In operation, base 12 is mounted in thermal communication with the heat generating component and heat is conveyed through base 12 to the heat pipes 16 and then to coolant block portion 14 where the heat is dissipated to a liquid coolant medium for further conveyance out of the fluid heat exchanger.

Base 12 may be formed in various ways and of various materials to permit mounting to accept heat energy from the heat generating component, to conduct thermal energy and to accept, support and be in thermal communication with heat pipes 16. The heat pipes may be thermally coupled to and/or arranged relative to base 12 in various ways. In the illustrated embodiment, base 12 is formed about a portion of each heat pipe 16, which portion thereby becomes the evaporator portion 18 of each heat pipe. To enhance operation of the heat exchanger, base 12 and heat pipe evaporator portions 18 may be formed and/or arranged such that elongate portions of the heat pipes pass through the base. For example base 12 may include an elongate dimension along which the heat pipes extend and are thermally coupled.

It will be appreciated that a heat pipe operates by phase change of a heat transfer, working medium between the heat pipe's evaporator portion 18 and condenser portion 20. Heat pipes generally include a closed envelope in which heat transfer working medium is contained. The heat transfer is achieved by vaporization of the working medium at the evaporator portion by action of received heat energy and condensation of the gaseous working medium at condenser portion 20, which is cooler due to its thermally conductive contact with portion 14 that permits dissipation of the heat energy. A circuit is set up within a heat pipe wherein working medium moves from the condenser portion to the evaporator portion by gravity flow or wicking action.

In the presently illustrated embodiment, the heat pipes are formed as hollow tubes. Heat pipes may take various forms. For example, heat pipes may be relatively straight or curved. In one embodiment, for example, one or more of the heat pipes may be L-shaped or U-shaped including an evaporator portion and an arm, defining the condenser portion, extending at an angle from the evaporator portion at one or both ends of the evaporator portion. The illustrated embodiment, for example, includes a heat pipe formed such that it has a first end 16' and an opposite end 16" and the first and opposite ends define condenser portions 20, while the heat pipe's evaporator portion 20 is positioned along the length of the pipe between its ends.

While other numbers and configurations of heat pipes may be used as desired, in the illustrated embodiment of Figures 4 and 5 there are three heat pipes 16a, 16b, 16c and each heat pipe includes an elongate evaporator portion (inside base 12) positioned between ends formed as heat pipe condenser portions 20a, 20b, 20c. In this way, evaporated working medium within the heat pipe may migrate to either end of the heat pipe to convey heat energy from the base to the coolant block portion. This may reduce the occurrence of heat pipe dry outs which sometimes occur in environments where the heat exchanger must operation under significant heat load. Ends 16' 16" may be straight upstanding or curved. For example, in the illustrated embodiment, both ends are curved to each include a return portion extending substantially parallel to the evaporator portion. The curved end returns are positioned in side by side relation with one end 16' running in direction opposite to the other end 16" such that the heat exchanger forms a compact arrangement. In the illustrated embodiment, the plurality of heat pipes define a plurality of returned ends that may be curved and positioned in side by side, spaced apart relation and coolant block portion 14 may be thermally coupled to the arranged ends 16' 16". The ends may be arranged substantially in a plane to facilitate connection to block portion 14. In one embodiment, the planar configuration of ends 16', 16", portion 14 and base 12 may be substantially in parallel to provide a compact arrangement.

The heat pipes may be attached to and/or arranged relative to coolant block portion 14 in various ways. In one embodiment, a plurality of coolant blocks may be used into each of which at least some of the heat sink pipe condenser portions are connected and thermally coupled. Alternately, a single coolant block portion may be used. Where both ends of an elongate heat pipe are formed as condenser portions, the ends may be configured, as by curving, to each be mounted in a single coolant block portion 14, which may reduce the overall size of the fluid heat exchanger. To facilitate operation of the heat exchanger, the heat pipe condenser portions may be formed such that elongate portions thereof are thermally coupled to the coolant block portion.

Coolant block, portion 14, in addition to its connection to heat pipes 16, includes a body with one or more liquid tight passages extending therethrough. The passages provide for conduction of liquid coolant, such as one or more of water, a glycol, a freon, etc., from a passage inlet through the body of portion 14 to a passage outlet Passages may be formed in various ways and configurations through coolant block portion 14 to permit flow of liquid coolant therethrough and heat-dissipating contact between the body of the coolant block portion and liquid coolant passing through the passages. Generally, a passage that provides expansive contact with body is desirable. In the illustrated embodiment, coolant block portion includes a passage 22 extending between barbs 24. Passage 22 is formed to contain the liquid coolant in a liquid tight manner and channel it between the barbs. In the illustrated embodiment, passage.22 is formed as an open area below an upper body cap 14a and includes internal dividers 23 to define the passage and channel and direct the flow of coolant through the body.

Thermal coupling between the parts may be provided by casting, welding, soldering, press fitting, thermally conductive adhesives or fillers, and many other ways as will be apparent to a skilled person. In the illustrated embodiment, portion 14 is formed of two parts: an upper part 26 including passage 22 extending therethrough and a clamping part 28 that can be clamped against upper part 26 with the heat pipe condenser portions 20 secured therebetween, as by use of screws 30. Corresponding grooves 32 may be fanned in interfacing surfaces of upper part 26 and clamping part 28 to form channels into which the heat pipes may be secured. Thermally conductive fillers can be used between heat pipes 16 and upper part 26. Of course, other modes of assembly and thermal coupling can be used, as desired.

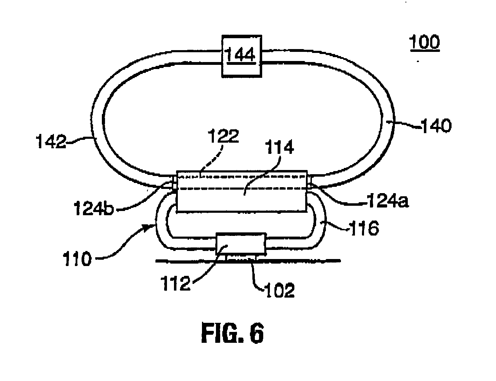

Referring to Figure 6, a computer cooling system 100 is shown for a heat-generating component 102 of the computer, The cooling system includes a fluid heat exchanger 110 including a base 112, a coolant block portion 114 and a heat pipe 116, each heat pipe including an evaporator portion 118 and a condenser portion 120. The evaporator portion of each heat pipe is attached and thermally coupled to the base and the condenser portion of each heat pipe is attached and thermally coupled to coolant block portion 114. Coolant block portion 114 includes a passage 122 to channel liquid coolant in a liquid tight manner between an inlet 124a and an outlet 124b.

Fluid heat exchanger 110 is included in the system to conduct heat away from heat generating component 102. To do so, base 112 is mounted in thermal communication with heat generating component 102 and heat is conveyed through base 112 to the heat pipes 116 and then to coolant block portion 114 where the heat is dissipated to a liquid coolant medium passing through passage 122 for further conveyance out of the fluid heat exchanger.

In the system, an inlet tube 140 may be connectable to inlet 124a and an cutlet tube 142 may be connectable to outlet 124b to conduct the liquid coolant in a circuit between a heat sink 144 and coolant block portion 114. The respective connections between inlet tube 140 and inlet 124a and between outlet tube 142 and outlet 124b may be liquid tight to avoid leakage of liquid coolant at these connection points.

The previous description of the disclosed embodiments is provided to enable any person skilled in the art to make or use the present invention. Various modifications to those embodiments will be readily apparent to those skilled in the art, and the generic principles defined herein may be applied to other embodiments without departing from the spirit or scope of the invention. Thus, the present invention is not intended to be limited to the embodiments shown herein, but is to be accorded the full scope consistent with the claims, wherein reference to an element in the singular, such as by use of the article "a" or "an" is not intended to mean "one and only one" unless specifically so stated, but rather "one or more". All structural and functional equivalents to the elements of the various embodiments described throughout the disclosure that are know or later come to be known to those of ordinary skill in the art are intended to be encompassed by the elements of the claims. Moreover, nothing disclosed herein is intended to be dedicated to the public regardless of whether such disclosure is explicitly recited in the claims. No claim element is to be construed under the provisions of 35 USC 112, sixth paragraph, unless the element is expressly recited using the phrase "means for" or "step for".

## Claims

1. A fluid heat exchanger comprising: a base, a heat pipe including an evaporator portion thermally coupled to the base and a condenser portion; a coolant block portion thermally coupled to the condenser portion of the heat pipe, the coolant block portion including a liquid tight passage extending from a passage inlet to a passage outlet.

2. The fluid heat exchanger of claim 1 wherein the passage inlet is formed as a barb.

3. The fluid heat exchanger of claim 1 wherein the passage outlet is formed as a barb.

4. The fluid heat exchanger of claim 1 further comprising internal dividers defining the liquid tight passage.

5. The fluid heat exchanger of claim 1 wherein the heat pipe includes an elongate return thermally coupled to the coolant block.

6. The fluid heat exchanger of claim 1 wherein the coolant block portion includes an upper portion and a clamping portion and the condenser portion of the heat pipe is clamped between the upper portion and the clamping portion.

7. A cooling system for a heat-generating component, the cooling system comprising: a fluid heat exchanger including a base, a heat pipe including an evaporator portion thermally coupled to the base and a condenser portion; a coolant block portion thermally coupled to the condenser portion of the heat pipe, the coolant block portion including a liquid tight passage extending from a passage inlet to a passage outlet

8. The cooling system of claim 7 further comprising a liquid coolant inlet tube connectable at the passage inlet.

9. The cooling system of claim 7 further comprising a liquid coolant outlet tube connectable at the passage outlet.

10. The cooling system of claim 7 further comprising a liquid coolant circuit in which the fluid heat exchanger is connected.

11. The cooling system of claim 10 wherein the liquid coolant circuit includes a liquid coolant inlet tube connected at the passage inlet, a liquid coolant outlet tube connected at the passage outlet and a heat sink connected between the liquid coolant outlet tube and the liquid coolant outlet tube.

12. The cooling system of claim 7 wherein the passage inlet is formed as a barb.

13. The cooling system of claim 7 wherein the passage outlet is formed as a barb.

14. The cooling system of claim 7 further comprising internal dividers defining the liquid tight passage.

15. The cooling system of clam 7 wherein the heat pipe includes an elongate return thermally coupled to the coolant block.

16. The cooling system of claim 7 wherein the coolant block portion includes an upper portion and a clamping portion and the condenser portion of the heat pipe is clamped between the upper portion and the clamping portion.
